Europäisches Patentamt

European Patent Office

Office européen des brevets

(19)

(11) Veröffentlichungsnummer: **0 268 876 B1**

# (12) EUROPÄISCHE PATENTSCHRIFT

(45) Veröffentlichungstag der Patentschrift: **16.10.91**

(51) Int. Cl.⁵: **H03H 17/02**

(21) Anmeldenummer: **87116096.6**

(22) Anmeldetag: **02.11.87**

(54) **Mehrdimensionale (k-dimensionales) Digitalfilter, das Addierer, Multiplizierer und Schiebeglieder enthält.**

(30) Priorität: **12.11.86 DE 3638570**

(43) Veröffentlichungstag der Anmeldung:
**01.06.88 Patentblatt 88/22**

(45) Bekanntmachung des Hinweises auf die
Patenterteilung:
**16.10.91 Patentblatt 91/42**

(84) Benannte Vertragsstaaten:
**AT BE CH DE FR GB IT LI NL SE**

(56) Entgegenhaltungen:

**PROCEEDINGS 6TH EUROPEAN CONFEREN-CE ON CIRCUIT THEORY AND DESIGN, Stuttgart, September 1987, Seiten 217-220; K. MEERKÖTTER: "Antimetric wave digital filters derived from complex reference circuits"**

**1986 IEEE INTERNATIONAL SYMPOSIUM ON CIRCUITS AND SYSTEMS, San Jose, California, 5.-7. Mai 1986, Band 2, Seiten 506-509, IEEE, New York, US; A. FETTWEIS: "Multidimensional wave digital filters - problems and progress"**

(73) Patentinhaber: **SIEMENS AKTIENGESELL-SCHAFT**
**Wittelsbacherplatz 2**
**W-8000 München 2(DE)**

(72) Erfinder: **Fettweis, Alfred, Prof. Dr.**
**Im Königsbusch 30**
**W-4630 Bochum(DE)**

**Beschreibung**

Die Erfindung betrifft ein mehrdimensionales (k-dimensionales) Digitalfilter gemäß dem Oberbegriff des Patentanspruches 1.

Filter dieser Art sind beispielsweise in der Zeitschrift IEEE Transactions on Circuits and Systems, Vol. Cas-31, No. 1, January 1984, Seiten 31 bis 48 bekannt. Es sind dort digitale Schaltungen und Systeme beschrieben, unter anderem auch sind mehrdimensionale digitale Filter beschrieben. Als spezielle digitale Filter sind z.B. aus der Zeitschrift AEÜ, Bd. 25, 1971, Seiten 79 bis 89 bzw. auch aus der DE-C-20 27 303 sogenannte Wellendigitalfilter bekannt geworden, die eine spezielle Gattung der digitalen Filter darstellen. Bei diesen Wellendigitalfiltern können klassische Filter unmittelbar nachgebildet werden. Schließlich sind auch aus der DE-C-26 39 568 mehrdimensionale Wellendigitalfilter bekannt geworden. Eine spezielle Gattung solcher Wellendigitalfilter ist in der Zeitschrift K. Meerkötter, "Antimetric wave digital filters derived from complex reference circuits", Proc. Eur. Conf. Circuit Theory and Design, Stuttgart, W. Germany, Sept 1983, Seiten 217 bis 220 bekannt. Es werden dort antimetrische Wellendigitalfilter behandelt, die von komplexen Bezugsschaltungen (Autor Klaus Meerkötter) abgeleitet sind. Es ist verständlich, daß die Anwendung solcher Filter in erheblichem Maß abhängt von der jeweils zur Verfügung stehenden Technologie. Die Fortschritte aber, die in der sogenannten VLSI-Technologie (very large scale integration) erzielt werden, bringen gegenüber früheren komplizierten und verhältnismäßig langsamen Rechnern realzeitmehrdimensionale Filter in den Bereich der praktischen Realisierung.

Der Erfindung liegt die Aufgabe zugrunde, mehrdimensionale digitale Filter anzugeben, bei denen die Zahl der erforderlichen Schaltelemente (hard ware) möglichst klein bleibt und unerwünschte Störungen, die durch die digitale Filtertechnik bedingt sind, möglichst klein bleiben. Angegeben werden auch digitale Filter mit geschlossenem Dämpfungsverhalten, die durch Methoden der komplexen Netzwerktheorie hergeleitet sind.

Diese Aufgabe wird erfindungsgemäß nach dem Patentanspruches 1 gelöst.

Vorteilhafte Ausgestaltungen sind in den Unteransprüchen angegeben.

Anhand von Ausführungsbeispielen wird nachstehend die Erfindung noch näher erläutert.

Es zeigen in der Zeichnung

Fig. 1     die Realisierung reeller Übertragungsfunktionen $S_{11}$ und $S_{21}$ durch ein komplexes Eintor mit der Übertragungsfunktion $S_a = S_{11} + jS_{21}$;

Fig. 2     die Realisierung einer komplexen Allpaßfunktion $S_i$ mit einer antimetrischen Übertragungsfunktion (Gleichung 41), $N_0$ enthält dabei nur reelle arithmetische Operationen und die doppelten Linien bedeuten Verbindungen von erforderlicher Vielfalt;

Fig. 3     die Größenverhältnisse für das einfachste mögliche Beispiel an den beiden Achsen $\omega_{1'}$, und $\omega_{2'}$.

Im folgenden werden mehrdimensionale digitale Filter beschrieben, die geschlossenes Dämpfungsverhalten haben und die entworfen sind mit Methoden der komplexen Netzwerktheorie. Gezeigt wird eine sehr vorteilhafte Näherung zum Entwurf von kompakten mehrdimensionalen Filtern mit geschlossenem Dämpfungsverhalten (z.B. einem Dämpfungsverhalten, das näherungsweise kreisförmig, sphärisch oder auf verwandte Weise symmetrisch verläuft). Der Entwurf ist abgestellt auf die Verwendung von Ergebnissen aus der Theorie der klassischen komplexen Schaltungen. Die sich ergebenen Übertragungsfunktionen können mit Hilfe von geeigneten mehrdimensionalen digitalen Filterstrukturen implementiert werden, insbesondere in Form von mehrdimensionalen Wellendigitalfiltern. Es ergeben sich damit sehr wirkungsvolle Entwurfsmöglichkeiten, die alle Vorteile bieten, die auch durch die Verwendung von Wellendigitalfiltern erreicht werden können.

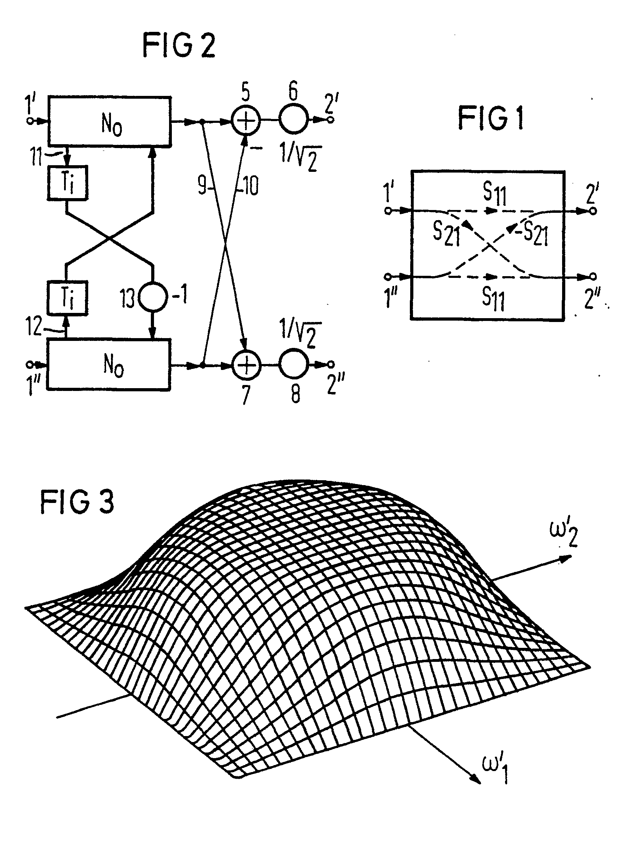

Fig. 1 zeigt allgemein eine Schaltung, die ein komplexes Eintor darstellt, was bedeutet, daß das Signal aus Real-und Imaginärteil besteht. Es ist deshalb der Eingang mit 1' und 1" bezeichnet. Die Richtungspfeile deuten an, daß Real- und Imaginärteil des Signals in das Eintor fließen. In entsprechender Weise besteht auch das Ausgangssignal aus Real- und Imaginärteil, weshalb die Ausgänge mit dem Bezugsziffern 2' und 2" bezeichnet sind. Durch die gestrichelten Linien innerhalb des komplexen Eintores ist kenntlich gemacht, wie die reellen Übertragungsfunktionen $S_{11}$ durch $S_{21}$ mit eine komplexe Übertragungsfunktion $S_a = S_{11} + jS_{21}$ realisiert werden. Es verläuft also die gestrichelte Linie mit der Bezeichnung $S_{11}$ von 1' nach 2' bzw. von 1" nach 2". Die gestrichelte Linie $S_{21}$ von 1' nach 2" und es muß in entsprechender Weise eine gestrichelte Linie $-S_{21}$ von 1" nach 2' verlaufen. Die Richtungspfeile sind auch dort eingezeichnet.

Im Blockschaltbild der Fig. 2 sind wirkungsgleiche Schaltungsstrukturen mit den gleichen Bezugsziffern wie in Fig. 1 bezeichnet. Dem Eingang 1' folgt ein Netzwerk $N_0$, das alle reellen arithmetischen Operationen ausführt. Über einen Addierer 5 (+) und eine Schaltung 6, die das Verhältnis $1/\sqrt{2}$ hat wird der Punkt 2' erreicht. Entsprechend führt auch der Eingang 1" auf ein Netzwerk $N_0$, das wiederum nur reelle arithmeti-

sche Operationen ausführen muß. Über einen Addierer 7 (+) und eine Schaltung 8, die wiederum das Verhältnis $1/\sqrt{2}$ bildet, wird der Ausgang 2' erreicht. Eine Leitung 9 führt vom Ausgang des oberen Netzwerkes $N_0$ zum Addierer 7, der ja im unteren Zweig liegt und es führt entsprechend eine Leitung 10 vom Ausgang des unteren Netzwerkes $N_0$ zum Addierer 5, der entsprechend im oberen Zweig liegt. In der Leitung 10 ist ein Minuszeichen (-), wodurch eine Phasenumkehr kenntlich gemacht werden soll. Eine vordere Ausgangsleitung 11 des oberen Netzwerkes $N_0$ führt über eine Schaltung $T_i$ über eine Schaltung 13, in der eine Phasenumkehr bewirkt wird (-1) zu einem hinteren Eingang des unteren Netzwerkes $N_0$. Entsprechend führt eine Leitung 12 vom vorderen Ausgang des unteren Netzwerkes $N_0$ über eine Schaltung $T_i$ zum hinteren Eingang des oberen Netzwerkes $N_0$. Für eindimensionale Filter ist diese Schaltung an sich aus der unter anderem eingangs genannten Literaturstelle [15] bekannt. Demgegenüber bedeuten in Fig. 2 alle dick ausgezogenen Linien mehrfache Schaltverbindungen, deren Vielfalt jeweils dem Grad der Allpaß-funktion $S_i$, die der i-ten Dimension zugeordnet ist, entspricht. Durch Kaskadierung von k Schaltungen der Art von Fig. 2, von denen jede einer anderen der k Dimensionen zugeordnet ist, wird also eine komplexe Allpaßfunktion $S_1$, $S_2$ ... $S_k$ realisiert, bei der die Schaltungsstruktur derart ausgebildet ist, daß ihre Übertragungsfunktion derjenigen eines antimetrischen Filters entspricht und dabei eine charakteristische Funktion hat, die eine rationale Funktion der Quadrate der äquivalenten komplexen Frequenzen ($\psi i$ mit i = 1 bis k) ist.

Fig. 3 zeigt die Größenverhältnisse für das einfachste mögliche Beispiel entlang zweier aufeinander senkrecht stehender Achsen $\omega_{1'}$ und $\omega_{2'}$.

Zur weiteren Erläuterung sei noch folgendes ausgeführt, wobei zugleich auf das am Ende angegebene Literaturverzeichnis, was jeweils in eckigen Klammern angegeben ist, hingewiesen wird.

Entsprechend dem jeweiligen Dämpfungsverhalten bestehen zwei große Gruppen mehrdimensionaler (MD) digitaler Filter und zwar solche, für die wir im allgemeinen sagen, daß ihr Verhalten offen ist und solche, für die wir im allgemeinen sagen, daß ihr Verhalten geschlossen ist. Zu den Filtern mit offenem Dämpfungsverhalten zählen die sogenannten Fächerfilter; für diese erstreckt sich die Grenze zwischen Durchlaß- und Sperrbereich bis zur entsprechenden Nyquistgrenze, oder wenn man eine passend transformierte Frequenzvariable benutzt, bis unendlich. Andererseits sind Filter mit geschlossenem Dämpfungsverhalten im wesentlichen durch die Tatsache charakterisiert, daß Linien (Oberflächen, Hyper-Oberflächen) die den Durchlaßbereich, den Übergangsbereich und den Sperrbereich trennen, geschlossen sind; zu solchen Filtern zählen insbesondere solche, deren Dämpfungsverhalten nahezu kreisförmige (sphärische, hypersphärische) Symmetrie haben, (obwohl bemerkt werden sollte, daß diese Art von extremer Symmetrie für die praktische Realisierung nicht notwendig ist). Einige allgemeine Literaturstellen über mehrdimensionale digitale Filter (MD) sind zum Beispiel die Literaturstellen [1] bis [4] .

Von einem gänzlich anderen Gesichtspunkt unterscheidet man in klassischen verlustfreien Schaltungen zwischen zwei hauptsächlichen Filterzweitortypen, solche die symmetrisch sind und solche die antimetrisch sind, die auch als antisymmetrisch bezeichnet werden. Diese Filter stellen auch den größeren Teil an Schaltungen dar, die als Referenzfilter für Wellendigitalfilter (WDF) [5] verwendet werden, und diese Überlegungen gehalten nicht nur für eindimensionale (1D) Wellendigitalfilter (WDF), sondern auch für mehrdimensionale Wellendigitalfilter (MD WDF) entsprechend den Literaturstellen [5] bis [7] . Eine interessante Beobachtung ist, daß symmetrische Zweitore besonders geeignet für den Entwurf von Fächerfiltern erscheinen, wie dies auch hervorgeht aus den entsprechenden Lösungen, die früher bereits in den Literaturstellen [5] , [8] bis [10] beschrieben wurde, während antimetrische Zweitore, wie im folgenden noch gezeigt wird, sich für den Entwurf von MD-Filtern (mehrdimensional) mit einem geschlossenen Dämpfungsverhalten eignen. Die erforderliche Übertragungsfunktion kann als Wellendigitalfilter realisiert werden, da damit auch alle deren Vorteile greifbar sind, ( [5] bis [7] , [11] ). Indessen ist auch eine Realisierung mit Hilfe von irgendeiner üblichen mehrdimensionalen digitalen Filternäherung gleichermaßen möglich, wenn dies gewünscht wird, aber die sich ergebende Realisierung im Licht der erforderlichen Koeffizientengenauigkeit, des Dynamikbereiches, der Stabilität und der endlichen arithmetischen Bedingungen und auch die Zahl der Multiplizierer und Addierer ist im allgemeinen wesentlich weniger attraktiv.

Für das anstehende Problem ist man im allgemeinen an reellen Filtern interessiert, aber die Entwicklung macht sehr stark Gebrauch von der Theorie der komplexen klassischen Schaltungen [12] , [13] und der von komplexen Wellendigitalfiltern [13] bis [15] . Der Grund dafür ist folgender. Es ist bekannt, daß für klassische symmetrische Zweitore eine kanonische Realisierung mit Hilfe von sogenannten Kreuzgliedstrukturen möglich ist, die zwei kanonische Reaktanzen enthalten; diese Reaktanzen sind reell. Für antimetrische Filter existieren keine ähnlichen kanonischen Strukturen mit reellen Reaktanzen, wohl aber ist sie möglich mit Hilfe von Strukturen die ähnlich denjenigen für reelle Zweitore sind, wenn zugelassen wird, daß die kanonischen Reaktanzen komplex sind ([13] bis [16].) Die Lösung die angegeben wird, ist wesentlich wirkungsvoller als alle bisherigen zum Entwurf von Wellendigitalfiltern mit geschlossenen Dämpfungsverhal-

3

ten entsprechend den Literaturstellen [5] bis [7] , [17] , [18] , einschließlich auch der in Literaturstelle [7] beschriebenen.

Während die Lösung, die man für Fächerfilter erhält, [5] , [8] , bis [10] und auch diejenigen, die auf kreuzantimetrische Bezugsfilter aufbaut, auf zweidimensionale (2D) Filter beschränkt ist, ist die hier beschriebene Lösung anwendbar auf jede beliebige Anzahl, k, auch auf Dimensionen wie z.B. k = 2 (was ebenfalls der Fall ist für die Entwurfsmethode die auf Drehungen beruht [5] bis [7] , [17] bis [20] . Selbst wenn man nur ganz näherungsweise Schätzungen für die Auswahl geeigneter Zahlenwerte anwendet, erhält man beachtlich gute Dämpfungsabhängigkeiten, und dies kann weiterhin durch Anwendung numerische Optimierungsmethoden verbessert werden.

Die Lösung beruht auf der Beobachtung, daß die sogenannte charakteristische Funktion eines Filters mit geschlossenem Dämpfungsverhalten vorzugsweise eine rationale Funktion der Quadrate der äquivalenten Frequenzparameter sein muß, wie dies später noch beschrieben wird. Nachdem im folgenden die allgemeinen Prinzipien noch beschrieben werden, wird später in einem eigenen Abschnitt gezeigt, daß die Lösung, die man erhält, vollständig in dem Sinn ist, daß sie die Gesamtheit aller möglichen mehrdimensionalen (MD) klassischen Filterstrukturen und damit auch die Gesamtheit aller mehrdimensionalen Wellendigitalfilter (MD WDF) umfaßt, für die die charakteristische Funktion die eben angegebene Eigenschaft hat.

Im folgenden sei noch eingegangen auf verlustfreie antimetrische Zweitore.

Wir gehen aus von a-Dimensionen und damit entsprechend k komplexen Frequenzen, $p_i = \sigma_i + j\omega_i$, $i = 1$ to k, , die wir zu einem k-Tupel zusammenfassen

$$\underline{p} = (p_1,...,p_k) . \qquad (1)$$

Es sei $T_i$ die Grundverschiebung in der Dimension i. Es ist wohl bekannt, daß es durchaus zulässig ist, anstelle der $p_i$ die Variablen

$$z_i = e^{-p_i T_i} \qquad (2)$$

zu betrachten oder äquivalent dazu die Variablen $\psi_i$,die folgendermaßen definiert sind:

$$\Psi_i = (1-z_i)/(1 + z_i = \tanh(p_i T_i/2) . \qquad (3)$$

Das entsprechende k-Tupel ist somit

$$\underline{\psi} = (\psi_1,...,\psi_k) . \qquad (4)$$

Die Variablen $\psi_i$ spielen die Rolle von (äquivalenten) komplexen Frequenzen. Für reelle Frequenzen, d.h. für $p_i = j\omega_i$ haben wir

$$\psi_i = j\phi_i , \phi_i = \tan(\omega_i T_i/2) . \qquad (5)$$

die Buchstaben $\omega_i$ und $\psi_i$ sind stets so anzunehmen, daß sie reelle Zahlen vertreten, und die entsprechenden k-Tupel sind

$$\underline{\omega} = (\omega_1,...,\omega_k) , \underline{\phi} = (\phi_1,...,\phi_k) . \qquad (6)$$

Es ist zweckmäßig, ein verlustloses Zweitor, das wir mit N bezeichnen wollen, durch seine Streumatrix darzustellen

$$\underline{S} = \begin{pmatrix} S_{11} & S_{12} \\ S_{21} & S_{22} \end{pmatrix} \qquad (7)$$

wobei $S_{21}$ und $S_{12}$ die beiden Transmittanten sind und $S_{11}$ und $S_{22}$ die beiden Reflektanzen sind [12] .

Bekanntlich können [21] , [22] können die Streumatrixen in die kanonische Form gebracht werden, die eine Verallgemeinerung derjenigen für den eindimensionalen Fall darstellt [12] , d.h.,

$$\underline{S} = \frac{1}{g} \begin{pmatrix} h & \gamma f_* \\ f & -\gamma h_* \end{pmatrix} \qquad (8)$$

wobei das folgende gilt:

1. f, g und h sind Polynome, die zueinander folgende Beziehung haben

$$gg_* = hh_* + ff_* ; \qquad (9)$$

in einem dieser Polynome kann einer der Koeffizienten beliebig gewählt werden.

2. g ist ein Streu-Hurwitz-Polynom, d.h., ist so, daß
   a) $g(\underline{\psi}) \neq 0$ für Re $\underline{\psi} > \underline{0}$,
   b) g und $g_*$
sind teilerfremd.

3. $\gamma$ ist eine unimodulare Konstante ($|\gamma| = 1$).

4. Der tiefgestellte Stern bedeutet die Parakonjugierte, d.h., für skalare Funktionen (die wir hier betrachten),

$$_* = f_*(\underline{\psi}) = f^*(-\underline{\psi}^*) \text{ etc.,} \qquad (10)$$

Der obenstehende Stern bedeutet eine komplexe Konjugation und $\psi^*$ ist das entsprechende k-Tupel

$$\underline{\psi}^* = (\psi_1^*,...,\psi_k^*) .$$

Diese Ergebnisse sind gültig unabhängig davon, ob N reell oder komplex ist; indessen sei noch folgendes hinzugefügt:

5. Wenn das Zweitor reell ist, können alle Koeffizienten in S reell gewählt werden, d.h., f, g und h sind dann reelle Polynome und $\gamma = \pm 1$, während wir auch haben $\overline{f_*} = f(-\underline{\psi})$ usw.

Für $\underline{\psi} = j\phi$ ist die Dämpfung $\alpha$ gegeben durch

$$\alpha = -\ln|S_{21}| = \tfrac{1}{2} \ln(1 + |\Psi|^2) \qquad (11)$$

wobei

$$\Psi = S_{11}/S_{21} = h/f \qquad (12)$$

Die sogenannte charakteristische Funktion von N ist, wenn N antimetrisch ist, dann haben wir, per Definition,

$$S_{21} = S_{12}, S_{11} = -S_{22} \qquad (13a,b)$$

und damit

$$h = \gamma h_* , f = \gamma f_* , \Psi_* = \Psi . \qquad (14a,b,c)$$

Umgekehrt, wenn die Gleichungen (13a) und (14c) gültig sind, dann ist dies auch für die Gleichung (13b), der Fall d.h., N ist dann antimetrisch.

Wir nehmen im folgenden an, daß N in der Tat antimetrisch ist. Wir führen neue Funktionen

$$S_a = S_{11} + jS_{21} , S_b = S_{11}-jS_{21} , \qquad (15)$$

ein, die somit im allgemeinen nicht reelle, sondern komplexe rationale Funktionen in $\underline{\psi}$ sind. Aus Gleichung (8) folgt, daß

$$S_a = (h+jf)/g \ , \ S_b = (h-jf)/g \qquad (16a,b)$$

und damit aus den Gleichungen (9) und (14a,b) daß

$$S_a S_{a^*} = S_b S_{b^*} = 1 \ . \qquad (17)$$

Damit sind $S_a$ und $S_b$ (komplexe) Allpaßfunktionen.

Es seien $g_a$ und $g_b$ Nenner mit dem niedrigsten Grad von $S_a$ und $S_b$. Es folgt dann aus Gleichung (16), das $g_a$ und $g_b$ die Größe g teilen und damit selbst Streu-Hurwitz-Polynome 22 sind. Demzufolge (wie dies nachgewiesen werden kann indem man beispielsweise $S_a = f_a/g_a$ schreibt und Gebrauch von Gleichung (17) macht), können $S_a$ und $S_b$ in folgender Form geschrieben werden

$$S_a = \gamma_a g_{a^*}/g_a \ , \ S_b = \gamma_b g_{b^*}/g_b \qquad (18a,b)$$

wobei $\gamma_a$ und $\gamma_b$ unimodulare Konstanten sind ($|\gamma_a| = |\gamma_b| = 1$). Umgekehrt, wenn man von Gleichung (18) ausgeht und $\overline{S}$ berechnet, indem man von den Gleichungen (13) und (15) Gebrauch macht, erhält man einen Ausdruck in der Form der Gleichung (8) gemäß Gleichung (19), wodurch auch Gleichung (9) erfüllt ist.

$$g = g_a g_b \ , \ h = (\gamma_a g_{a^*} g_b + \gamma_b g_a g_{b^*})/2$$
$$\gamma = \gamma_a \gamma_b \ , \ f = (\gamma_a g_{a^*} g_b - \gamma_b g_a g_{b^*})/2j \qquad (19)$$

Wir wollen jetzt spezieller annehmen, daß N ein reelles antimetrisches Zweitor ist. Selbst dann, sind jedoch $S_a$ und $S_b$ komplexe Funktionen (im Lichte der Gleichung (15)) sind und das gleiche gilt auch für die Größen $g_a$ und $g_b$, während $\gamma_a$ und $\gamma_b$ ebenfalls komplex sein können. Darüberhinaus sind $S_a$ und $S_b$ jetzt durch Gleichung (20) verknüpft,

$$S_b = \overline{S}_a \ , \ S_a = \overline{S}_b, \qquad (20)$$

wobei zu bemerken ist, daß eine Notation wie $S_a$ definiert ist durch $\overline{S}_a (\psi) = S_a^* (\psi^*)$ und damit die Bikonjugierte von $S_a$ darstellt [15] . Aus den Gleichungen (18) und (20) kann geschlossen werden daß, (möglicherweise nach Hinzufügen eines geeigneten reellen Faktors beispielsweise zur Größe $g_b$) die Gültigkeit von Gleichung (21) angenommen werden kann

$$g_b = \overline{g}_a \ , \ \gamma_b = \gamma_a^* . \qquad (21)$$

Darüberhinaus folgt aus Gleichung (15) daß

$$S_{11} = Ra \ S_a = (S_a + \overline{S}_a)/2 \ , \ S_{21} = Ia \ S_a = (S_a - \overline{S}_a)/2j \qquad (22a,b)$$

wobei Ra den realanalytischen (oder den realytischen) Teil bedeutet, während Ia den imaginäranalytischen (oder den imalytischen) Teil der betrachteten Funktion bedeutet. (Es sei daran erinnert, daß für eine analytische Funktion, etwa $F = F (\psi)$, Ra F und Ia F ebenfalls analytische Funktionen in $\psi$ sind, im Gegensatz zu dem, was für Re F und $\overline{Im}$ F der Fall ist, und daß wir für eine reelle Funktion $\overline{F} = \overline{F}$ haben.)

Man kann aus den Gleichungen (12), (18) und (22) schließen, daß

$$\Psi = j(1+\rho)/(1-\rho) = -d'/d'' \qquad (23)$$

wobei

$$\rho = \overline{S}_a/S_a = d/\overline{d} \qquad (24)$$

und d, d' und d'' die Polynome sind, die durch Gleichung (25) definiert sind

$$d = \gamma_a^* \ g_a \overline{g}_{a^*} \ , \ d' = Ra \ d, \ d'' = Ia \ d \ . \qquad (25)$$

6

EP 0 268 876 B1

Offensichtlich ist $\overline{g}_{a*}(\psi) = g_a(-\psi)$ so daß d ein gerades Polynom in $\psi$ ist. Darüberhinaus haben wir $\overline{\rho} = 1/\rho$ und damit $\overline{\Psi} = \Psi$, was bestätigt, daß $\Psi$ eine reelle gerade Funktion in $\overline{\psi}$ ist.

Wenn man umgekehrt von einem gegebenen (komplexen) Hurwitz-Polynom $g_a$ und irgendeiner unimodularen Konstante $\gamma_a$ ausgeht, kann man $S_a$ und $S_b$ mit Hilfe der Gleichungen (18) und (21) herleiten und damit S mit Hilfe der Gleichungen (13) und (22). Die eben beschriebenen Eigenschaften für d und $\Psi$ sind dann erfüllt. Indessen benötigt die Synthese von N, nicht die Betrachtung der Gleichung (19), sondern sie kann durch allgemeine Entwurfsverfahren, wie sie beispielsweise in der Literaturstelle [14] beschrieben sind, oder direkt unter Verwendung von Gleichung (15) und damit Gleichung (22) [13] erfolgen. In der Tat, wenn man in einem komplexen Eintor mit der Übertragungsfunktion H die reellen (1') und imaginären (1") Eingangsgrößen ebenso wie die reellen (2') und imaginären (2") Ausgangsgrößen für sich getrennt betrachtet, sind die reellen Übertragungsfunktionen von 1' nach 2' und die von 1" nach 2" gegeben durch Ra H, während die von 1' nach 2" gegeben ist durch Ia H und die von 1" nach 2' durch -Ia H. Damit folgt aus Gleichung (22), das für ein komplexes Eintor mit der Übertragungsfunktion $S_a$ die reellen Übertragungsfunktionen $S_{11}$ und $S_{21}$ so erhalten werden, wie dies in Fig. 1 gezeigt ist [13] . Auf diese Weise wird das Problem der Synthese eines reellen verlustlosen antimetrischen Zweitores auf die Synthese eines verlustlosen, jedoch komplexen, Eintores reduziert.

Im folgenden sei noch eingegangen auf Zweitore mit geschlossenem Dämpfungsverhalten, wobei zunächst die Herleitung einer geeigneten charakteristischen Funktion gezeigt wird.

Wenn man geschlossenes Dämpfungsverhalten haben will, haben die tatsächlichen Forderungen im allgemeinen irgendeine Form der Symmetrie, die sich mathematisch in der Form

$$\alpha\ (j\epsilon_1\phi_1,\ldots,j\epsilon_k\phi_k)\ =\ \alpha\ (j\phi_1,\ldots,j\phi_k)$$

ausdrücken läßt, wobei für irgendein $i\epsilon\{l,\ldots,k\}$ man entweder $\epsilon_i = 1$ oder $\epsilon_i = -1$. Für $k = 2$ entspricht eine solche Forderung der quadrantalen Symmetrie [23] , [24] . Es wäre am besten, wenn der Betrag der Transmittanz $S_{21}$ diese Symmetrie besäße, würde, oder, was auf dasselbe hinausläuft, wenn die reelle rationale Funktion $\Psi$ eine entsprechende Symmetrie hätte (vergleiche Gleichung (11)). Diee Forderung ist offensichtlich erfüllt, wenn $\Psi$ für $\psi = j\ \phi$, rational ist in den $\phi_i^2$, d.h., wenn $\Psi$ rational ist in den $\psi_i^2$, $i = 1$ bis k. In diesem Fall wird die Gleichung (14c) klar befriedigt. Folglich kann man versuchen eine Lösung mit Hilfe eines reellen anitmetrischen Zweitores zu finden, oder, was dazu äquivalent ist, mit Hilfe eines komplexen Eintores mit einer Allpaß-Übertragungsfunktion $S_a$. Dies erfordert im wesentlichen, ein komplexes Hurwitz-Polynom $g_a$ zu finden, während das Vorhandensein der Konstanten $\gamma_a$ eine zusätzliche weitere Freiheit bringt.

Um ein solches geeignetes Polynom $g_a$ zu finden, sei angenommen, daß wir $g_a$ in Faktorform schreiben können

$$g_a\ =\ g_1 g_2 \ldots g_k \qquad (26)$$

wobei für alle $i = 1$ bis k, $g_i = g_i(\psi_i)$ nur von $\psi_i$ abhängt. In diesem Fall kann das Polynom d wie es durch Gleichung (25) definiert ist in folgender Form geschrieben werden

$$d\ =\ \gamma_a^*\ \prod_{i=1}^{k}\ d_i\ , \qquad\qquad\qquad (27)$$

wobei sich ergibt, da $\overline{g}_{i*}(\psi_i) = g_i(-\psi_i)$,

$$d_i\ =\ g_i(\psi_i)\ g_i(-\psi_i)\ , \qquad (28)$$

d.h., $d_i = d_i(\psi_i^2)$ ist tatsächlich ein Polynom in $\psi_i^2$ und dies gilt auch für $\overline{d}_i$. Daher folgt aus den Gleichungen (23) und (24), daß die reelle Funktion $\Psi$ nicht nur rational und gerade ist in $\psi$, sondern tatsächlich eine reelle rationale Funktion ist in den individuellen $\psi_i^2$, und damit in $(\psi_1^2,\ldots,\psi_k^2)$.

Im folgenden seien noch einige spezielle Entwurfsprinzipien angegeben.

Im allgemeinen sind die an ein Filter zu stellenden Anforderungen derart, daß man nicht erwarten kann, daß man in der Lage ist, eine direkte analytische Prozedur zu finden, mit der man eine auf den vorigen Ergebnissen beruhende, optimale charakteristische Funktion bestimmen könnte. Aus diesem Grund sind

$$S_o = S_o(\psi_1),\ \rho_o = \rho_o(\psi_1^2),\ \text{and}\ \psi_o = \psi_o(\psi_1^2)$$

7

im allgemeinen numerische Optimierungen notwendig. Trotzdem ist es interessant, den Fall etwas näher zu überprüfen, daß das gewünschte Ergebnis symmetrisch in allen Variablen ist. In diesem Fall benötigen wir nur ein einziges unterschiedliches Polynom, nämlich $g_o$ und wir können dann schreiben

$$g_i = g_o (\psi_i) \, , \, i = 1 \text{ to } k. \qquad (29)$$

Betrachtet man insbesondere das Verhalten entlang einer Hauptachse, beispielsweise entlang der Achse $\psi_2 = \ldots = \psi_k = 0$. Dann reduzieren sich $S_a$, $\rho$, und $\psi$ sich zu Ausdrücken die miteinander folgendermaßen verknüpft sind.

$$S_o = \gamma_o g_{o*}(\psi_1)/g_o(\psi_1) \, , \qquad (30)$$
$$\Psi_o = j(1 + \rho_o)/(1-\rho_o) \, , \, \rho_o = (j\Psi_o + 1)/(j\Psi_o - 1) \, . \qquad (31a,b)$$

Dabei ist die unimodulare Konstante $\gamma_o$ gegeben durch

$$\gamma_o = \gamma_a \, [ \, | \, g_o(0)|/g_o(0)]^{2k-2} \qquad (32)$$

Für $\rho_o$ erhalten wir

$$\rho_o = \overline{S}_o/S_o = d_o/\overline{d}_o \qquad (33)$$

wobei das Polynom $d_o = d_o(\psi_i^2)$ definiert ist durch

$$d_o(\psi_i^2) = \dot{\gamma}_o \, g_o(\psi_1)g_o(-\psi_1). \qquad (34)$$

Der Entwurf kann jetzt weitergehen, indem man eine geeignete eindimensionale reelle rationale Funktion $\Psi_o(\psi_i^2)$ wählt. Weil $\overline{\Psi}_o = \Psi_o$ ist, schließt man aus Gleichung (31), daß das resultierende $\rho_o$ folgende Bedingung erfüllt:

$$\overline{\rho}_o = 1/\rho_o. \qquad (35)$$

Man kann folglich ein Polynom $d_o$ finden, für das die Bedingung $\rho_o = d_o/\overline{d}_o$ gilt (vergleiche Gleichung (33)). Wenn man in der Tat $\rho_o = a/b$ schreibt, wobei a und b teilerfremde Polynome sind, dann findet man unter Berücksichtigung von Gleichung (35), daß diese der Bedingung $a\overline{a} = b\overline{b}$ genügen. Sie sind somit nicht nur vom gleichen Grad, sondern dergestalt, daß

$$a = \overline{b}q \, , b = \overline{a}q$$

gilt, wobei q eine Konstante ist, für die man $|q| = 1$ findet. Demzufolge kann man $d_o = \pm \, a \, (q^*)^{\frac{1}{2}}$ wählen. Daraus ergibt sich, daß das resultierende $d_o$ teilerfremd ist mit $\overline{d}_o$.

Nun können wir ein (komplexes) Hurwitz-Polynom $g_o(\psi_1)$ und eine unimodulare Konstante $\gamma_o$ so bestimmen, daß Gleichung (34) befriedigt wird. Dies ist immer möglich, da $d_o$, das gerade in $\psi_1$ und teilerfremd mit $\overline{d}_o$ ist, keine Nullstellen gemeinsam mit $\overline{g}_o$ haben kann; es wird dadurch klar, daß auch das resultierende $g_o$ teilerfremd mit $\overline{g}_o$ ist. Es wird dann $\gamma_a$ mit Hilfe von Gleichung (32) und $g_a$ mit Hilfe der Gleichungen (26) und (29) bestimmt.

Die eben erläuterte Methode läßt sich leicht verallgemeinern für den Fall, daß man ein anderes Verhalten entlang einer der Hauptachsen wählt. Wenn ein etwas allgemeineres Verhalten gewünscht wird, beginnt man damit, daß man die $g_i(\psi_i)$ in einer geeigneten parametrischen Form schreibt, beispielsweise in der Form

$$g_i(\psi_i) = \prod_{\nu} (\psi_i + a_{i\nu} + jb_{i\nu})$$

wobei die $a_{i\nu}$ und $b_{i\nu}$ Konstante sind mit $a_{i\nu} 0$. Danach wird eine beliebige unimodulare Konstante $\gamma_a$ gewählt und $g_a$ wird unter Zuhilfenahme von Gleichung (26) erhalten. Die $a_{i\nu}$ und $b_{i\nu}$ ebenso wie das $\gamma_a$ werden dann durch eine geeignete Optimierungsmethode bestimmt.

Unabhängig davon, welche Methode man verwendet, wird schließlich die Synthese vervollständigt durch das Auffinden einer geeigneten Struktur zur Realisierung von $S_a$. Eine Möglichkeit dafür besteht in folgendem. Benutzt man die Gleichungen (18a) und (26), kann man $S_a$ in folgender Form schreiben.

$$S_a = \gamma_a' \, S_1 S_2 ... S_k \qquad (36)$$

Dabei ist

$$S_i = \gamma_i g_{i*}/g_i \, , \, \gamma_a' = \gamma_a \dot{\gamma_1} \dot{\gamma_2} ... \dot{\gamma_k} \qquad (37)$$

wobei die $\gamma_i$, für i = 1 bis k, willkürliche unimodulare Konstanten sind.

Mit Ausnahme der Konstanten $\gamma'_a$, die zu berücksichtigen trivial ist, wird die Synthese somit reduziert auf die Realisierung der einzelnen k eindimensionalen Allpaß-Funktionen $S_i$. Wie in den Literaturstellen [13] bis [15] gezeigt ist, ist dies immer möglich, insbesondere mit Hilfe von Wellendigitalfilter-Strukturen (WDF).

Einige interessante Spezialfälle lassen sich betrachten. Ein erster tritt auf, wenn unter der Annahme, daß die Gleichungen (29) und damit (30) bis (35) gelten, $\Psi_o$ bireziproke ist, d.h., dergestalt ist daß Gleichung (38) gilt,

$$\Psi_o(1/\psi_1^2) = 1/\, \Psi_o(\psi_1^2) \, . \qquad (38)$$

Definiert man $\rho_o' = \rho_o'\,(\psi_1^2)$ und $S_o' = S_o'\,(\psi_1)$ durch $\rho_o'\,(\psi_1^2) = \rho_o(1/\psi_1^2)\,, \, S_o'\,(\psi_1) = S_o(1/\psi_1)\,,$

dann ist Gleichung (38) äquivalent zu $\rho\,'_o = -1/\rho_o$ und damit im Hinblick auf die erste Gleichheit in Gleichung (33) zu

$$S_o S_o' = -\,\overline{S}_o\overline{S}_o' \, . \qquad (39)$$

Man beachte, daß im Hinblick auf die Gleichungen (5) und (11) die Gleichung (39) ausdrückt, daß $\alpha$ und die entsprechende Dämpfung $\alpha_{1\,1} = -\ell n|S_{11}|$ in $\omega$, spiegelbildlich zueinander sind bezüglich $\pi/2T_1$ und daß gilt

$$e^{-2\alpha(\pi/2T_1 - \omega_1)} + e^{-2\alpha(\pi/2T_1 + \omega_1)} = 1 \, .$$

Offensichtlich sind $S_o$, $S_o'$, $\overline{S}_o$ und $\overline{S}'_o$ Allpaßfunktionen und haben alle den gleichen Grad. Da $\rho_o = \overline{S}_o/S_o$ ist und die Streu-Hurzwitz-Polynome $g_o$ und $\overline{g}_o$ teilerfremd sind, haben $S_o$ und $\overline{S}_o$ außerdem keinen gemeinen Allpaßfaktor (d.h., vom Grad $\geq$ 1). Damit schließen wir aus Gleichung (39), daß $\overline{S}_o = \gamma S'_o$ gilt, wobei $\gamma$ eine Konstante ist, und damit ist $\overline{S}'_o = \gamma S'_o$. Setzt man diese Ausdrücke in Gleichung (39) ein, dann erhält man $\gamma^2 = -1$, d.h. $\gamma = \pm j$, und damit

$$\overline{S}_o = \pm jS_o' \, . \qquad (40)$$

Wählt man schließlich $\gamma_i = \gamma_o$ für i = l bis k, so liefern die Gleichungen (29) und (37)

$$S_i(\psi_i) = S_o(\psi_i) \, , \, i = 1 \text{bis k,}$$

so daß Gleichung (40) äquivalent ist zu

$$\overline{S}_i(\psi_i) = \pm jS_i(1/\psi_i) \, , \, i = 1 \text{ bis k} \, . \qquad (41)$$

Wenn man $\psi_i$ durch $1/\psi_i$ ersetzt, was dem Ersetzen von $z_i$ durch $-z_i$ entspricht, so erkennt man aus den Gleichungen (2) und (3), daß Gleichung (41) äquivalent ist zur Bedingung (13) in der Literaturstelle [15] . Damit kann die Realisierung der Allpaßfunktionen $S_i\,(\psi_i)$ in der gleichen Weise ausgeführt, wie sie in Literaturstelle [15] beschrieben ist.

Eine entsprechende Struktur ist in Fig. 2 gezeigt, wobei die stark ausgezogenen Linien Verbindungen geeigneter Vielfalt, etwa der Vielfalt m bedeuten. Insbesondere ist zu beachten, daß, wenn die Signalfilterung mit einer Halbierung oder Verdoppelung der Abtastrate verbunden ist, die arithmetischen Funktionen in den verschiebefreien Baugruppen, die mit $N_o$ bezeichnet sind, mit der niedrigeren der betrachteten Abtastraten ausgeführt werden können (wie man in Fig. 2 durch Weiterschieben einer der mit $T_i$ bezzeichneten m-fachen Verschiebungen erkennen kann). Zur Erläuterung von 1', 1″, 2' und 2″, vergleiche Fig. 1. Wenn man darüberhinaus Argumente benutzt, ähnlich denjenigen, die im Anhang A von Literaturstelle [25] erläutert sind, kann man zeigen, daß im allgemeinen die gleichen Vereinfachungen für die Realisierung von $N_0$ auch hier erhalten werden, wie dies z.B. in den Literaturstellen [25] und [26] diskutiert wird.

Der zweite interessante Spezialfall, den man beachten kann, sei nur kurz erwähnt. Anstelle einer Realisierung der gewünschten Symmetrie entlang den Hauptachsen, wie dies durch Gleichung (38) ausgedrückt ist, läßt sich das gleiche entlang den Diagonalen erreichen. Betrachtet man $\Psi$ als Funktion von $(\psi_1^2,...,\psi_k^2)$, dann ist die gewünschte Beziehung

$$\Psi(1/\psi_1^2,...,1/\psi_k^2) = 1/\Psi(\psi_1^2,...,\psi_k^2)$$

für $\psi_1^2 = \psi_2^2 = ... = \psi_k^2$.

Es sind eine Reihe von Verallgemeinerungen dieser Spezialfälle in solchen Fällen möglich, in denen die $g_i$ nicht einfach durch Gleichung (29) gegeben sind. In vielen praktischen Fällen wird keiner dieser Lösungsansätze zu einer wirklich brauchbaren Lösung führen. In solchen Fällen sollte man eine verallgemeinerte Methode verwenden, beispielsweise in dem man das Verhalten der charakteristischen Funktion gleichzeitig entlang den Koordinatenachsen und entlang den Diagonalen berücksichtigt.

Im folgenden seien noch Beispiele angegeben.

Man betrachtet zunächst den einfachsten Typ des Polynoms $g_0$, d.h.

$$g_0(\psi) = \psi + a + jb, a > 0;$$

dabei sind a und b Konstanten. Darüberhinaus wählt man eine unimodulare Konstante $\gamma_a = \gamma' + j\gamma''$ wobei $\gamma'$ und $\gamma''$ reell sind. Für $d'$ und $d''$, die durch Gleichung (25) definiert sind, findet man,

$$d' = \gamma'\psi_1^2\psi_2^2 + (\gamma'(b^2-a^2)-2\gamma''ab)(\psi_1^2 + \psi_2^2) + \gamma'(a^4 + b^4-6a^2b^2) + 4\gamma''ab(a^2-b^2)$$
$$d'' = \gamma''\psi_1^2\psi_2^2 + (\gamma''(b^2-a^2) + 2\gamma'ab)(\psi_1^2 + \psi_2^2) + \gamma''(a^4 + b^4-6a^2b^2) + 4\gamma'ab(b^2-a^2),$$

wobei $\gamma'^2 + \gamma''^2 = 1$ ist. Entsprechend der Gleichung (23) ergibt sich $\Psi = d'/d''$.

Wir nehmen jetzt an, daß die durch Gleichung (38) ausgedrückte Symmetrie vorliegt und benutzen diese Gleichung als Ausgangspunkt. Wegen der Gleichungen (31), (33), und (34) ist $\Psi_0$ bilinear in $\psi_1^2$, und man erhält dann aus Gleichung (38)

$$\Psi_0 = (\psi_1^2 + c)/(c\psi_1^2 + 1) = (\phi_1^2 - c)/(c\phi_1^2 - 1)$$

(oder das Negative dieses Ausdruckes), wobei c eine reelle Konstante ist. Man erhält so aus Gleichung (31b),

$$\rho_0 = j(\psi_1^2 - \epsilon^2)/(\epsilon^2\psi_1^2 - 1)$$

wobei $\epsilon^2$ eine unimodulare Konstante ist, die gegeben ist durch

$$\epsilon^2 = (c-j)/(jc-1). \qquad (42)$$

Für $d_0$ findet man, wenn man so vorgeht, wie dies im Anschluß an Gleichung (35) erläutert wurde,

$$d_0 = \pm(\psi_1^2 - \epsilon^2)(1 + j)/\epsilon\sqrt{2}$$

und man kann dann wählen (vergleiche Gleichung (34)),

$$g_0 = \psi_1 + \epsilon, \gamma_0 = \mp(1-j)\epsilon/\sqrt{2}$$

und erhält (vergleiche Gleichung (32))

$$\gamma_a = \mp(1-j)\epsilon^3/\sqrt{2} = \gamma' + j\gamma''. \qquad (43)$$

Mit

$$\epsilon = a + jb,$$

wobei wir diejenige Wurzel aus Gleichung (42) wählen für die a 0 ist, sind dann alle Parameter bekannt.

Der einfachste Fall ergibt sich für c = 0. Man erhält dann

$a = b = 1/\sqrt{2}$, $\gamma' = 0$, $\gamma'' = 1$, und damit

$$\Psi = (\psi_1^2 + \psi_2^2)/(1 - \psi_1^2 \psi_2^2).$$

Das resultierende $|S_{21}|$, gezeichnet für eine Drehung der Daten um $\pm 45°$ (und damit, auch der Frequenzebene um $\pm 45°$), ist in Fig. 3 gezeigt.

Genauer ausgedrückt ist die Transformation, die auf $\omega_1$ und $\omega_2$ angewendet wurde,

$$\omega'_1 = \omega_1 - \omega_2, \quad \omega'_2 = \omega_1 + \omega_2.)$$

Im folgenden werden noch einige Angaben über die Vollständigkeit gemacht, und es sei zunächst die Vollständigkeit der Lösung gezeigt.

Die beschriebene Lösung ist tatsächlich vollständig, d.h., sie umfaßt alle charakteristischen Funktionen, die rational in $\psi_i^2$, i = 1 bis k, sind. Um dies nachzuweisen, betrachtet man folgendes Theorem, dessen Beweis nachstehend noch gegeben wird. Dieses Theorem ist eine Verallgemeinerung verwandter Theoreme in den Literaturstellen [23] und [24].

Theorem 1

Betrachtet sei eine reelle oder komplexe Übertragungsfunktion $H = H(\underline{\psi})$,

$$H = f/g \quad (44)$$

wobei $f = f(\psi)$ und $g = g(\psi)$ teilerfremde Polynome sind und g ein Streu-Hurwitz-Polynom der aus den Literaturstellen [21] [22] und [27] bekannten Art ist. Falls H frei ist von Allpaß-Faktoren und sich der Wert von $|H(j\phi)|$ nicht ändert, wenn irgendeines der $\phi_i$, $i\epsilon\{1,...,k\}$, ersetzt wird durch das entsprechende $-\phi_i$, kann g auf die Form gebracht werden

$$g = \gamma g_1 g_2 ... g_k \quad (45)$$

wobei $g_i = g_i(\psi_i)$ für jedes $i\epsilon\{1, ...,k\}$ ein reelles Polynom ist, das nur von $\psi_i$ abhängt, und $\gamma$ eine unimodulare Konstante ist.

Benutzt man dieses Theorem (für den Fall einer reellen Übertragungsfunktion), so läßt sich die Vollständigkeit der beschriebenen Lösung leicht nachweisen. Dazu betrachtet man irgendein verlustloses Zweitor, dessen charakteristische Funktion die gewünschte Symmetrie hat und das deshalb notwendigerweise antimetrisch ist. Gemäß den Gleichungen (8) und (22b) hat man

$$S_{21} = f/g = (S_a - \overline{S}_a)/2j$$

wobei $S_a$ durch Gleichung (16) definiert ist und damit in der Form der Gleichung (18a) geschrieben werden kann, und zwar unter Berücksichtigung der dort angegebenen Einzelheiten. Wie wir in dem Absatz im Anschluß an Gleichung (17) gesehen haben, ist $g_a$ ein Teiler von g, und damit kann $g_a$ entsprechend Gleichung (44) in der Form

$$g_a = g_{a1} g_{a2} ... g_{ak}$$

geschrieben werden, wobei $g_{ai} = g_{ai}(\psi_i)$ für jedes $i\epsilon\{1,...,k\}$ ein Polynom ist, das nur von $\psi_i$ abhängt. Bemerkt sei, daß eine unimodulare Konstante wie $\gamma$ in Gleichung (45) z.B. in $\gamma_a$ aufgenommen werden kann (vergleiche Gleichung (18a)). Der Beweis verläuft entsprechend, wenn anstelle von $S_{21}$ die Funktion $S_{11}$ betrachtet worden wäre.

Beweis von Theorem 1

Der Beweis von Theorem 1 folgt unmittelbar aus den Hilfssätzen 1 und 4, die im folgenden angegeben werden.

Hilfssatz 1.

Wir betrachten eine reelle oder komplexe Übertragungsfunktion H = f/g, wobei f und g teilerfremde Polynome in $\psi$ sind, g ein (reelles oder komplexes) Streu-Hurwitz-Polynom ist und weiterhin H frei von Allpaß-Faktoren sein möge. Nimmt man weiterhin an, daß der Wert von |H(j$\phi$)| sich nicht ändert, wenn irgendwelche der $\phi_i$, i$\epsilon$\{1,...,k\} ersetzt werden durch die entsprechenden -$\phi_i$, dann bleiben auch |f(j$\phi$)| und |g-(j$\phi$)| einzeln unverändert, wenn irgendeine der soeben erwähnten Vertauschung vorgenommen wird.

Beweis.

Man beachte zuerst, daß die Hauptannahme des Hilfssatzes darauf hinausläuft, zu sagen, der Wert von

$$H(j\epsilon_1\phi_1,...,j\epsilon_k\phi_k) \cdot H^*(j\epsilon_1\phi_1,...,j\epsilon_k\phi_k) \qquad (46)$$

bliebe unverändert, wenn für die $\epsilon_i$, i = 1 bis k, irgendeine Kombination von Werten ±1 gewählt wird. Entsprechend läuft die Aussage des Hilfssatzes darauf hinaus, zu sagen, der Wert von

$$g(j\epsilon_1\phi_1,...,j\epsilon_k\phi_k) \, g^*(j\epsilon_1\phi_1,...,j\epsilon_k\phi_k) \qquad (47)$$

bliebe unverändert, wenn die $\epsilon_i$ so gewählt werden, wie dies soeben festgelegt wurde. Durch analytische Fortsetzung folgt aus der Hauptannahme, daß

$$\frac{f(\epsilon_1\psi_1,...,\epsilon_k\psi_k) \, f_*(\epsilon_1\psi_1,...,\epsilon_k\psi_k)}{g(\epsilon_1\psi_1,...,\epsilon_k\psi_k) \, g_*(\epsilon_1\psi_1,...,\epsilon_k\psi_k)} = \frac{f(\psi)f_*(\psi)}{g(\psi)g_*(\psi)} \qquad (48)$$

gelten muß, und zwar für alle zulässigen Auswahlmöglichkeiten der $\epsilon_i$.

Auf der rechten Seite der Gleichung (48) kann keine Kürzung vorgenommen werden. Da nämlich f und g teilerfremd sind, würden andernfalls f und $g_*$ einen gemeinsamen Faktor, etwa $d_*$, enthalten. In diesem Fall wäre d ein Faktor von g und wäre somit ein Streu-Hurzwitz-Polynom (vergleiche Korollar 3.1 in Literaturstelle [22] ), d.h., H würde den Allpaß-Faktor $d_*$/d enthalten, was jedoch ausgeschlossen wurde. Somit folgt aus Gleichung (48), daß die Beziehungen

$$f(\epsilon_1\psi_1,...,\epsilon_k\psi_k) \, f_*(\epsilon_1\psi_1,...,\epsilon_k\psi_k) = K \, f(\psi) \, f_*(\psi) , \qquad (49)$$
$$g(\epsilon_1\psi_1,...,\epsilon_k\psi_k) \, g_*(\epsilon_1\psi_1,...,\epsilon_k\psi_k) = K \, g(\psi) \, g_*(\psi) \qquad (50)$$

für alle zugelassenen $\epsilon_i$ gelten, wobei K im Prinzip ein Polynom ist. Wendet man die Gleichungen (49) oder (50) für $\epsilon_1 = ...\epsilon_k = 1$ an, so findet man K = 1, d.h., für jede zugelassene Wahl der i, i = 1 bis k, muß gelten

$$g(\epsilon_1\psi_1,...,\epsilon_k\psi_k) \, g_*(\epsilon_1\psi_1,...,\epsilon_k\psi_k) = g(\psi) \, g_*(\psi). \qquad (51)$$

Man beachtet, daß die Aussage des Hilfssatzes etwas allgemeiner gefaßt werden kann, indem man sagt, daß die gemachten Annahmen implizieren, daß auch die Gleichungen (49) und und (50) für K = 1 gelten, wenn die $\epsilon_i$, für i = 1 bis k, irgendeinen der vorstehend zugelassenen Werte annehmen.

Hilfssatz 2.

Es sei g ein Streu-Hurwitz-Polynom in $\psi$ (vergleiche Gleichung (4)). Wir teilen die Variablen $\psi_i$, i = 1 bis k, in beliebiger Weise auf, indem nur sie zu einem k′-Tupel $\psi'$ und einem k′-Tupel, $\psi''$ zusammenfassen, mit 1≤k″≤k, k′ + k″ = k, und wir drücken entsprechend g in der Form g($\psi'$, $\psi''$) aus. Dann ist g($\psi'$, -$\psi''$) genau dann ein Streu-Hurwitz-Polynom, wenn g unabhängig von $\psi''$ ist.

Beweis.

Die Bedingung ist offensichtlich hinreichend. Um zu zeigen, daß sie auch notwendig ist, nehmen wir an, daß das Polynom h, das durch h($\psi'$, $\psi''$) = g($\psi'$, -$\psi''$) definiert ist, ein Streu Hurwitz-Polynom ist. Wir betrachten einen festen Wert von $\psi'$, beispielsweise $\psi'_0$, mit Re $\psi'_0$>0 und definieren ein Polynom $g_1$ in $\psi''$

durch $g_1(\underline{\psi}'') = g(\underline{\psi}'_o, \underline{\psi}'')$. Wie aus der Literaturstelle [27] bekannt ist, ist $g_1$ ein Streu-Hurwitz-Polynom, das dieselben Grade (d.h., Teilgrade) in den zu $\underline{\psi}''$ gehörigen $\psi_i$ hat, wie $g(\underline{\psi}', \underline{\psi}'')$. Wenn also g von wenigstens einem der $\psi_i$, die zu $\underline{\psi}''$ gehören tatsächlich abhängt, dann besteht (vergleiche Theorem 3 der Literaturstelle [22] ) ein $\underline{\psi}_o'$ mit Re $\underline{\psi}_o' > 0$, so daß $g_1(-\underline{\psi}_o') = 0$ ist, d.h., daß $h(\underline{\psi}_o', \underline{\psi}_o') = 0$ ist. Dies ist unmöglich, da ein Streu-Hurwitz-Polynom in $\underline{\psi}$ keine Nullstellen für Re $\underline{\psi} > \underline{0}$ hat.

Hilfssatz 3.

Es sei $g = g(\underline{\psi})$ ein reelles oder komplexes Streu-Hurwitz-Polynom in $\underline{\psi}$. Dann ist $g(-\underline{\psi})$ teilerfremd mit g-$(\underline{\psi})$.

Beweis.

Das Ergebnis ist trivial, wenn g reell ist (da dann $g_*(\underline{\psi}) = g(-\underline{\psi})$) gilt, aber es bedarf eines Beweises, wenn g komplex ist. Nehmen wir also an, daß g $(\underline{\psi})$ und $g(-\underline{\psi})$ einen eigentlichen gemeinsamen Faktor $d-d(\underline{\psi})$ haben (d.h., einen gemeinsamen Faktor vom Grad $\geq 1$). Dann ist d ebenfalls ein Streu-Hurzwitz-Polynom (vergleiche Korollar 3.1 von Literaturstelle [22] ).
Damit existiert ein $\psi_o$ mit Re $\underline{\psi}_o > \underline{0}$ so, daß $d(-\underline{\psi}_o) = 0$ ist (vergleiche Theorem 3 der Literaturstelle [22] ), d.h., daß $g(\underline{\psi}_o) = 0$.

Hilfssatz 4.

Es sei g ein reelles oder komplexes Streu-Hurwitz-Polynom in $\psi$ vom Grad $\geq 1$. Dann sind notwendige und hinreichende Bedingungen dafür, daß sich der Wert von $|g(j\phi)|$ nicht ändert, wenn irgendeines der $\phi_i$ ersetzt wird durch das entsprechende $-\phi_i$, daß g in der Form der Gleichung (45) geschrieben werden kann, wobei $g_i$ für alle $i \in \{1,...,k\}$ ein reelles Polynom in $\psi_i$ allein ist und $\gamma$ eine Konstante ist, die reell oder komplex sein kann.

Beweis.

Die Bedingungen sind offensichtlich hinreichend, um zu zeigen, daß sie auch notwendig sind, beachte man zuerst, daß man gemäß Gleichung (51) insbesondere hat

$$g(\underline{\psi}) \, g_*(\underline{\psi}) \; = \; g(-\underline{\psi}) \, g_*(-\underline{\psi}) \; ,$$

was äquivalent istzu

$$g(\underline{\psi}) \, g^*(-\underline{\psi}^*) \; = \; g(-) \, g^*(\underline{\psi}^*) \; .$$

Da durch $g(-\underline{\psi})$ gemäß Hilfssatz 3 teilerfremd ist mit $g(\underline{\psi})$, muß man haben

$$g(-\underline{\psi}) \; = \; K \, g^*(-\underline{\psi}^*) \; , \; g(\underline{\psi}) \; = \; K \, g^*(\underline{\psi}^*) \; . \qquad (52)$$

Diese beiden Ausdrücke sind äquivalent und man findet, das $|K| = 1$ ist, d.h. K ist nicht nur ein Polynom, sondern eine unimodulare Konstante. Wir können deshalb eine andere unimodulare Konstante $\gamma$ so wählen, daß $K = \gamma^2$ ist. Definiert man $g' = \gamma^*_g$, dann schließt man aus Gleichung (52), daß $g'(\underline{\psi}) = g'^*(\underline{\psi}^*)$, d.h., daß g' ein reelles Polynom ist.
Sei dann d ein eigentlicher, reeller, irreduzibler Faktor von g (d.h. ein reeller Faktor vom Grad $\geq 1$ der irreduzibel ist über dem Körper der reellen Zahlen).
Dieser ist ein Streu-Hurwitz-Polynom, das wenigstens eines der $\psi_i$, etwa $\psi_k$, enthält. Andererseits muß Gleichung (51) wiederum in der angebenen Weise gelten, d.h., wählt man $\epsilon_1 = ... = \epsilon_{k-1} = 1$, $\epsilon_k = -1$ und schreibt $g(\underline{\psi}', \psi_k)$ anstelle von $g(\underline{\psi})$ usw., mit $\underline{\psi}' = (\psi_1,...,\psi_{k-1})$ dann erhält man

$$g(\underline{\psi}', \psi_k) \, g_*(\underline{\psi}', \psi_k) \; = \; g(\underline{\psi}', -\psi_k) \, g_*(\underline{\psi}', -\psi_k) \; .$$

Somit muß $d = d(\underline{\psi}'\psi_k)$ entweder $g(\underline{\psi}', -\psi_k)$ oder $g_*(\underline{\psi}', -\psi_k)$ teilen. Wenn die erste dieser beiden Alternativen zuträfe, könnte man schließen, wenn man $\psi_k$ durch $-\psi_k$ ersetzt, daß $d(\underline{\psi}', -\psi_k)$ ein Teiler von g-$(\underline{\psi}', \psi_k)$ und damit selbst ein Streu-Hurwitz-Polynom wäre, in welchem Fall wegen Hilfssatz 2, tatsächlich d

unabhängig von $\psi_k$ wäre, im Gegensatz zu unserer Annahme. Wenn indessen die zweite unserer beiden erwähnten Alternativen zuträfe, könnte man ähnlich schließen, daß $d_*(\psi', -\psi_k)$ ein Teiler von $g(\psi', \psi_k)$ und somit auch ein Streu-Hurwitz-Polynom wäre, d.h., da d ein reelles Polynom und damit $d_*(\psi'-\psi_k)=d(-\psi',\psi_k)$ ist, das $d(-\psi', \psi_k)$ ein Streu-Hurwitz-Polynom wäre. Wenn man also wiederum den Hilfssatz 2 anwendet, findet man, daß d von $\psi'$ unabhängig ist.

Literaturverzeichnis:

1. T.S. Huang (editor), "Picture Processing and Digital Filtering", Springer-Verlag, Berlin, Germany, 1975.

2. T.S. Huang (editor), "Two-dimensional Digital Signal Processing I", Springer-Verlag, Berlin, Germany, 1981.

3. D.E. Dudgeon and R.M. Mersereau, "Multidimensional Digital Signal Processing", Prentice-Hall, Englewood Cliffs, N.J., 1984.

4. A. Fettweis, "Multidimensional circuits and systems theory", Tutorial Lecture, Proc. IEEE Int. Symp. Circuits Syst., vol. 3, pp. 951-957, Montreal, Canada, May 1984.

5. A. Fettweis, "Wave digital filters: Theory and practice", Proc. IEEE, vol. 74, pp. 270-327, February 1986.

6. A. Fettweis, "Principles of multidimensional wave digital filtering", published in: J.K. Agarwal (editor), "Digital Signal Processing", North Hollywood, CA: Western Periodicals, 1979.

7. A. Fettweis, "Multidimensional wave digital filters - problems and progress", Proc. IEEE Int. Symp. on Circuits and Systems, vol. , pp. , San Jose, CA, May 1986.

8. A. Fettweis, "Design of recursive quadrant fan filters", Arch. Elektr. Übertr., vol. 34, pp. 97-103, March 1980.

9. G. Linnenberg, "Wave digital fan filters: numerical and experimental results", Proc. Eur. Signal Processing Conf., Pp. 15-19, Lausanne, Switzerland, Sept. 1980 (published by North Holland, Amsterdam).

10. G. Linnenberg, "Über die diskrete Verarbeitung mehrdimensionaler Signale unter Verwendung von Wellendigitalfiltern", Doctoral Dissertation, Ruhr-Universität Bochum, Bochum, W. Germany, Jan. 1984.

11. A. Fettweis, "Suppression of parasitic oscillations in multidimensional wave digital filters", IEEE Trans. Circuits Syst., vol. CAS-25, No. 12, pp. 1060-1066, Dec. 1978.

12. V. Belevitch, "Classical Network Theory", Holden-Day, San Francisco, 1968.

13. K. Meerkötter, "Complex passive networks and wave digital filters", Proc. Eur. Conf. Circuit Theory and Design", vol. 2, pp. 24-35, Warsaw, Poland, Sept. 1980.

14. A. Fettweis, "Principles of complex wave digital filters", Int. J. Circuit Theory Appl., Vol. 9, pp. 119-134, April 1981.

15. K. Meerkötter, "Antimetric wave digital filters derived from complex reference circuits", Proc. Eur. Conf. Circuit Theory and Design, Stuttgart, W. Germany, Sept. 1983.

16. H.-P. Okolowitz, "Zur Synthese verlustfreier Zweitore durch Faktorzerlegung der Betriebskettenmatrizen" Doctoral Dissertation, Ruhr-Universität Bochum, West Germany, Feb. 1971.

17. P. Lennarz and L. Hofmann, "Computer realization of two-dimensional wave digital filters", Proc. 1978 Eur. Conf. Circuit Theory and Design, pp. 360-364, Lausanne, Switzerland, Sept. 1978.

18. P.A. Lennarz and W. Drews, "Design of circularly symmetric 2-D wave digital filters", Proc. Second Eur. Signal Processing Conf., pp. 199-202, Erlangen, W. Germany, Sept. 1983.

19. J.L. Shanks and S. Treitel, "Stability and synthesis of two-dimensional recursive filters", IEEE Trans. Audio and Electroacoustics, vol. AU-20, pp. 115-128, June 1972.

20. J.M. Costa and A.N. Venetsanopoulos, "Design of circularly symmetric two-dimensional recursive filters", IEEE Trans. Acoust., Speech, and Signal Processing, vol. ASSP-22, pp. 432-443, Dec. 1974.

21. A. Fettweis, "On the scattering matrix and the scattering transfer matrix of multidimensional lossless two-ports", Arch. Elektr. Übertr., vol. 36, pp. 374-381, Sept. 1982.

22. A. Fettweis, "Some properties of scattering Hurwitz polynomials", Arch. Elektr. Übertr., vol. 38, pp. 171-176, May-June 1984.

23. P. Karivaratharajan and M.N.S. Swamy, "Some results on the nature of a 2-dimensional filter function possessing certain symmetry in its magnitude response", Electronic Circuits and Systems, vol. 2, pp. 147-153, Sept. 1978.

24. P. Kariavatha Rajan, Harnatha C. Reddy, and M.N.S. Swamy, "Fourfold rational symmetry in two-dimensional functions", IEEE Trans. Acoustics, Speech, Signal Processing, vol. ASSP-30, pp. 488-499, June 1982.

25. A. Fettweis, J.A. Nossek, and K. Meerkötter, "Reconstruction of signals after filtering and sampling rate reduction", IEEE Trans. Acoustics, Speech, Signal Processing, vol. ASSP-33, pp. 893-902, Aug. 1985.
26. L. Gazsi, "Explicit formulae for lattice wave digital filters", IEEE Trans. Circuits, Syst., vol. CAS-32, pp. 68-88, Jan. 1985.
27. A. Fettweis and S. Basu, "New results on multidimensional Hurwitz polynomials", Proc. 1985 Int. Symposium on Circuits and Systems, vol. 3, pp. 1359-1362, Kyoto, Japan, June 1985.

## Patentansprüche

1. Mehrdimensionales (k-dimensionales) Digitalfilter, das Addierer, Multiplizierer und Schiebeglieder enthält,
   **dadurch gekennzeichnet,**
   daß die Schaltungsstruktur derart ausgebildet ist, daß ihre Übertragungsfunktion derjenigen eines antimetrischen Filters entspricht und dabei eine charakteristische Funktion hat, die eine rationale Funktion der Quadrate der äquivalenten komplexen Frequenzen ($\psi_i$ mit i = 1 ...k) ist.

2. Digitalfilter nach Anspruch 1,
   **gekennzeichnet durch**
   seine Ausbildung als Wellendigitalfilter (WDF).

3. Digitalfilter nach Anspruch 2,
   **dadurch gekennzeichnet,**
   daß das Wellendigitalfilter durch die reellen Übertragungsfunktionen eines mehrdimensionalen komplexen Allpasses realisiert ist.

4. Digitalfilter nach Anspruch 3,
   **dadurch gekennzeichnet,**
   daß die mehrdimensionale komplexe Allpaßübertragungsfunktion als Produkt von komplexen Einzelallpaßfunktionen in jeweils nur einer Frequenzvariablen ($\psi_i$) gebildet ist.

5. Digitalfilter nach Anspruch 4,
   **dadurch gekennzeichnet,**
   daß für mindestens eine der Einzelallpaßfunktionen
   $S_i(\psi_i)$ die Beziehung

$$S_i^*(\psi_i^*) = j\, S_i\,(1/\psi_i),\ i = 1...k$$

   gilt, wobei der Stern (*) den Übergang auf die konjugiert komplexe Größe und j die imaginäre Einheit bedeuten.

## Claims

1. Multidimensional (k-dimensional) digital filter comprising summers, multipliers and shift elements, characterised in that the circuit structure is designed such that its transfer function corresponds to that of an antimetric filter and has in this regard a characteristic function which is a rational function of the squares of the equivalent complex frequencies ($\psi_i$ where i = 1 ...k).

2. Digital filter according to Claim 1, characterised by its design as a wave digital filter (WDP).

3. Digital filter according to Claim 2, characterised in that the wave digital filter is realised by the real transfer functions of a multidimensional complex all-pass filter.

4. Digital filter according to Claim 3, characterised in that the multidimensional complex all-pass transfer function is formed as the product of complex individual all-pass functions in only one frequency variable ($\psi_i$) in each case.

5. Digital filter according to Claim 4, characterised in that the relationship

$$S_i^* (\psi_i^*) = j\ S_i\ (1/\psi_i),\ i\ =\ 1...k,$$

the asterisk (*) signifying the transition to the complex conjugate quantity and j the imaginary unit, holds for at least one of the individual all-pass functions $S_i(\psi_i)$.

**Revendications**

1. Filtre numérique multidimensionnel (à k dimensions), qui comporte des additionneurs, des multiplicateurs et des circuits à décalage, caractérisé par le fait que la structure du circuit est agencée de telle sorte que sa fonction de transfert correspond à celle d'un filtre antimétrique, et possède une fonction caractéristique qui est une fonction rationnelle des carrés des fréquences complètes équivalentes ($\psi_i$ avec i = 1 ... k).

2. Filtre numérique suivant la revendication 1, caractérisé par sa réalisation sous la forme d'un filtre numérique d'ondes (WDF).

3. Filtre numérique suivant la revendication 2, caractérisé par le fait que le filtre numérique d'ondes est réalisé au moyen des fonctions de transfert réelles d'un filtre passe-tout complexe multidimensionnel.

4. Filtre numérique suivant la revendication 3, caractérisé par le fait que la fonction de transmission passe-tout complexe multidimensionnelle est formée par le produit de fonctions passe-tout individuelles complexes avec respectivement une seule variable de fréquence ($\psi_i$).

5. Filtre numérique suivant la revendication 4, caractérisé par le fait que pour au moins l'une des fonctions passe-tout individuelles $S_i(\psi_i)$ on a la relation

$$S_i^*(\psi_i^*) = j\ S_i\ (1/\psi_i),\ i\ =\ 1...k,$$

l'astérisque (*) désignant le passage à la grandeur complexe conjuguée et j l'unité imaginaire.

## FIG 2

## FIG 1

## FIG 3